# EUROPÄISCHE PATENTANMELDUNG

(11) **EP 0 833 450 A1**
(43) Veröffentlichungstag der Anmeldung: **01.04.1998**
(21) Anmeldenummer: 95105127.5
(22) Anmeldetag: 05.04.1995
(51) Int. Cl.: H03K 19/003, G05F 3/26

(54) **Integrierte Pufferschaltung**

(71) Anmelder: SIEMENS AKTIENGESELLSCHAFT, 80333 München (DE)
(72) Erfinder: Kowarik, Oskar, Dr., D-85579 Neubiberg (DE)

(57) **Zusammenfassung**

Integrierte Pufferschaltung mit einem von der Versorgungsspannung unabhängigen Ausgangsstrom. Die Pufferschaltung weist eine zwischen einem ersten (VDD) und einem zweiten (Masse) Versorgungspotential angeordnete Serienschaltung (S) mindestens einer spannungsgesteuerten Konstantstromquelle (I) und eines ersten Feldeffekttransistors (T1) auf, bei der das Gate des ersten Feldeffekttransistors (T1) den Eingang (IN) der Pufferschaltung bildet und ein Schaltungsknoten (A) der Serienschaltung (S) zwischen der Konstantstromquelle (I) und dem ersten Feldeffekttransistor (T1) den Ausgang (OUT) der Pufferschaltung bildet. Die Konstantstromquelle (I) ist über einen Steuereingang (G) mit einem Referenzpotential (Vref) steuerbar, welches gegenüber dem ersten Versorgungspotential (VDD) eine konstante Potentialdifferenz aufweist. Es ist ein Doppelstromspiegel zur Erzeugung des Referenzpotentials vorgesehen.

## Beschreibung

Die Erfindung betrifft eine integrierte Pufferschaltung nach dem Oberbegriff des Patentanspruchs 1.

Pufferschaltungen werden in integrierten Schaltkreisen häufig benötigt, beispielsweise um Eingangssignale der Schaltkreise an schaltkreisintern geforderte Signaleigenschaften (zum Beispiel Pegel) anzupassen oder um Ausgangssignale von Schaltungen an nachfolgende weitere Schaltungen anzupassen. Nachteilig bei Pufferschaltungen ist bekanntlich ihre Empfindlichkeit gegenüber Störungen (zum Beispiel Rauschen) auf den Leitungen für die Versorgungsspannung. Ihre Funktion ist weiterhin stark abhängig von bei der Versorgungsspannung eventuell auftretenden Spannungsschwankungen, dies insbesondere dann, wenn die Pufferschaltung Signale mit TTL-Pegel in solche mit CMOS-Pegeln umsetzen soll (TTL-Pegel: ≤0,8V und ≥2,4V; CMOS-Pegel: meist 0V und 4V bis 6V, typisch: 5V).

Im Zuge der fortschreitenden Miniaturisierung von integrierten Schaltungen kommen chipintern zunehmend niedrigere CMOS-Pegel zum Einsatz (zum Beispiel 0V und 3,3V). Oftmals ist es dabei erwünscht, den integrierten Schaltkreis wahlweise mit einer Versorgungsspannung für herkömmliche, höhere CMOS-Pegel oder mit einer niedrigeren Versorgungsspannung für niedrigere CMOS-Pegel zu betreiben.

Aus der EP-A 0 587 938 ist eine integrierte Pufferschaltung bekannt, welche eine spannungsgesteuerte Konstantstromquelle aufweist, die weitgehend unabhängig von Störungen auf den Leitungen für die Versorgungsspannung ist. Diese Konstantstromquelle wird über einen Steuereingang durch ein Referenzpotential gesteuert, welches gegenüber einem der Versorgungspotentiale eine konstante Potentialdifferenz aufweist. Die Konstantstromquelle ist aber nur bezüglich relativ kleiner Schwankungen der Versorgungsspannung von dieser unabhängig, da das Referenzpotential sonst nicht mehr dieselbe Potentialdifferenz gegenüber dem Versorgungspotential aufweist. Bei größeren Schwankungen der Versorgungsspannung um mehrere Volt beziehungsweise beim Betrieb der Schaltung mit unterschiedlich hohen Versorgungsspannungen (beispielsweise einmal für höhere CMOS-Pegel, ein andermal für niedrigere CMOS-Pegel) ist der von der Konstantstromquelle gelieferte Ausgangsstrom der Pufferschaltung nicht mehr konstant.

Ein konstanter Ausgangsstrom der Pufferschaltung ist jedoch erwünscht, um bei gleicher kapazitiver Last am Ausgang einen versorgungsspannungsunabhängigen Schaltpunkt und eine versorgungsspannungsunabhängige Schaltzeit der Pufferschaltung zu gewährleisten.

Der vorliegenden Erfindung liegt die Aufgabe zugrunde, eine integrierte Pufferschaltung zu finden, welche einen vom Versorgungspotential unabhängigen Ausgangsstrom liefert.

Diese Aufgabe wird durch eine gattungsgemäße Pufferschaltung mit den kennzeichnenden Merkmalen des Patentanspruchs 1 gelöst.

Vorteilhafte Aus- und Weiterbildungen der Erfindung sind in den Unteransprüchen gekennzeichnet.

Die Erfindung wird nachstehend anhand der Zeichnung näher erläutert. Es zeigen:
- Figuren 1 und 2: Ausführungsformen der Erfindung,
- Figuren 3 bis 6: Ausführungsformen von Einzelheiten der Erfindung.

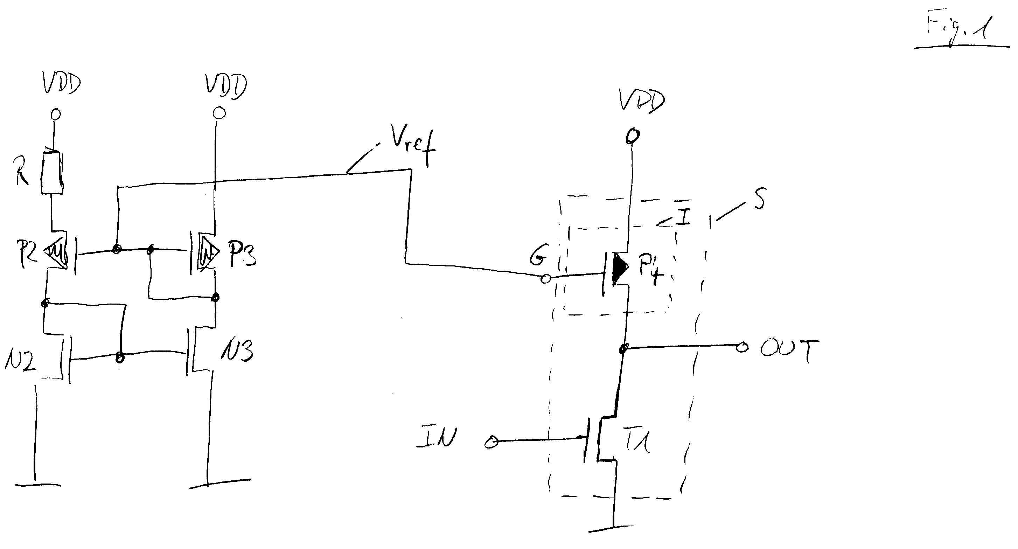

Als ein erstes Ausführungsbeispiel der Erfindung zeigt Figur 1 eine integrierte Pufferschaltung, welche in einer Serienschaltung S einen ersten Feldeffekttransistor T1 vom n-Kanal-Typ und einen als eine Konstantstromquelle I fungierenden Transistor vom p-Kanal-Typ aufweist, der im folgenden als vierter Feldeffekttransistor P4 bezeichnet wird. Die Serienschaltung S ist zwischen einem ersten Versorgungspotential VDD und einem zweiten Versorgungspotential Masse der Pufferschaltung angeordnet.

Für die im folgenden geschilderten Ausführungsbeispiele wird angenommen, daß das zweite Versorgungspotential Masse ein konstantes Bezugspotential ist und das zweite Versorgungspotential VDD Schwankungen unterworfen sein kann. Außerdem soll die Pufferschaltung mit ersten Versorgungspotentialen VDD unterschiedlicher Höhe betrieben werden können.

Weiterhin ist der vierte Feldeffekttransistor P4 mit dem ersten Versorgungspotential VDD und der erste Feldeffekttransistor T1 mit dem zweiten Versorgungspotential Masse verbunden. Das Gate des ersten Feldeffekttransistors T1 bildet den Eingang IN der integrierten Pufferschaltung. Der Schaltungsknoten zwischen dem ersten Feldeffekttransistor T1 und dem vierten p-Kanal-Feldeffekttransistor P4 bildet den Ausgang OUT der Pufferschaltung.

Ein Steuereingang G der Konstantstromquelle I wird durch das Gate des vierten Feldeffekttransistors P4 gebildet. Der Strom, welcher von der Konstantstromquelle I geliefert wird, soll unabhängig von Änderungen des ersten Versorgungspotentials VDD sein. Daher muß gewährleistet sein, daß die Gate-Source-Spannung des in Sättigung betriebenen vierten Feldeffekttransistors P4 auch bei Änderungen des ersten Versorgungspotentials VDD konstant bleibt. Ein an das Gate G des vierten Feldeffekttransistors P4 anzulegendes Referenzpotential Vref muß also auch bei Änderungen des mit seiner Source verbundenen ersten Versorgungspotentials VDD gegenüber diesem eine konstante Potentialdifferenz aufweisen.

Dieses Referenzpotential Vref wird mittels eines Doppelstromspiegels erzeugt, welcher nachfolgend beschrieben wird: Zwischen dem ersten Versorgungspotential VDD und dem zweiten Versorgungspotential Masse sind ferner ein Widerstandselement R, ein zweiter p-Kanal-Transistor P2 und ein zweiter n-Kanal-Transistor N2 in Serie angeordnet. Zwischen den beiden Versorgungspotentialen VDD, Masse sind außerdem ein dritter p-Kanal-Transistor P3 und ein dritter n-Kanal-Transistor N3 in Serie angeordnet. Die Gates des zweiten P2 und dritten P3 p-Kanal-Transistors sind miteinander verbunden. Gleiches gilt für die Gates des zweiten N2 und dritten N3 n-Kanal-Transistors. Außerdem sind Gate und Drain des dritten p-Kanal-Transistors P3 und des zweiten n-Kanal-Transistors N2 jeweils miteinander verbunden.

Ferner sind die Gates des zweiten P2 und dritten P3 p-Kanal-Transistors mit dem Steuereingang G der Konstantstromquelle I verbunden. An ihnen entsteht das Referenzpotential Vref.

Das Widerstandselement R kann beispielsweise ein ohmscher Widerstand oder ein als Widerstand verbundener Transistor sein.

Der Strom durch das Widerstandselement R ist unabhängig von Änderungen des ersten Versorgungspotentials VDD. Dieser konstante Strom verursacht am Widerstandselement R einen konstanten Spannungsabfall. Somit weist das Referenzpotential Vref gegenüber dem ersten Versorgungspotential VDD immer eine konstante Potentialdifferenz auf. Als Folge dessen erzeugt die Konstantstromquelle I sowohl bei Schwankungen des ersten Versorgungspotentials VDD als auch beim Betrieb mit einem niedrigeren oder einem höheren ersten Versorgungspotential VDD (beispielsweise 3,3 oder 5V) jederzeit einen Strom konstanter Stärke.

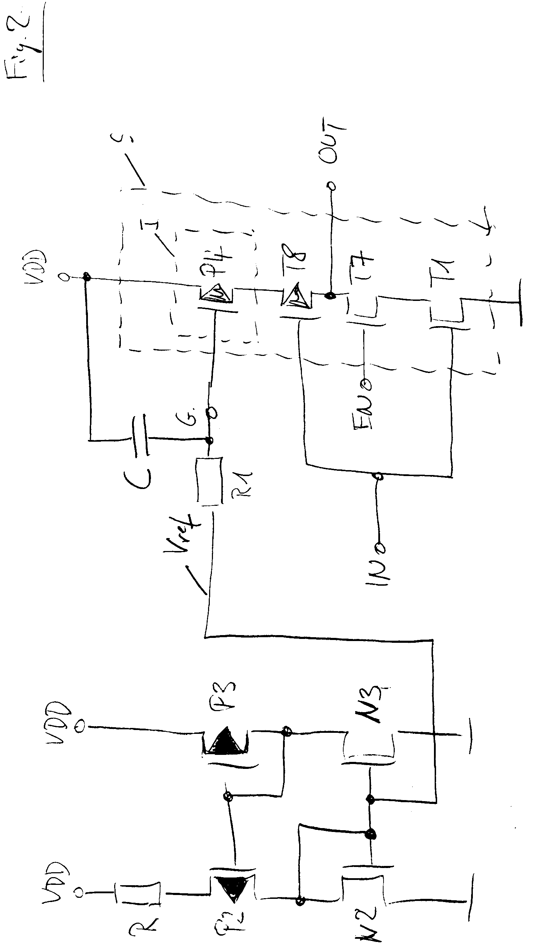

Figur 2 zeigt ein weiteres Ausführungsbeispiel der Erfindung, bei welchem die Pufferschaltung einen CMOS-Inverter aufweist. Der CMOS-Inverter beinhaltet den ersten Feldeffekttransistor T1 vom n-Kanal-Typ, dessen Source mit Masse verbunden ist. Seine Drain ist über einen siebten Feldeffekttransistor T7 vom n-Kanal-Typ mit einem achten Feldeffekttransistor T8 vom p-Kanal-Typ verbunden. Die Gates des ersten Feldeffekttransistors T1 und des achten Feldeffekttransistors T8 sind miteinander verbunden und bilden den Eingang IN der Pufferschaltung. Der Ausgang OUT der Pufferschaltung befindet sich an einem Schaltungsknoten der Serienschaltung S zwischen dem siebten Feldeffekttransistor T7 und dem achten Feldeffekttransistor T8. Das Gate des siebten Feldeffekttransistors T7, welcher bei anderen Ausführungsformen der Erfindung auch entfallen kann, bildet einen Enable-Eingang EN der Pufferschaltung. Daneben ist auch die Anordnung weiterer Enable-Transistoren möglich. Mittels des Enable-Eingangs EN ist der CMOS-Inverter aktivierbar.

Auch bei dem Ausführungsbeispiel gemäß Figur 2 ist die Konstantstromquelle I durch den vierten Feldeffekttransistor P4 vom p-Kanal-Typ realisiert. Das Referenzpotential Vref wird wiederum mit dem Doppelstromspiegel aus Figur 1 erzeugt. Das Gate G des vierten Feldeffekttransistors P4 ist diesmal allerdings über einen ersten Widerstand R1 mit den Gates des zweiten N2 und des dritten N3 n-Kanal-Transistors verbunden und nicht mit denjenigen des zweiten P2 und dritten P3 p-Kanal-Transistors. Außerdem ist das Gate G über einen Kondensator C mit dem ersten Versorgungspotential VDD verbunden. Der Kondensator C und der erste Widerstand R1 dienen zur Dämpfung von Störungen der Versorgungspotentiale. Sie können auch entfallen.

Besonders vorteilhaft ist es, wenn der zweite p-Kanal-Feldeffekttransistor P2 die gleichen elektrischen Eigenschaften wie der vierte Feldeffekttransistor P4 aufweist. Dies führt zu einer Kompensation von Temperatureinflüssen und von Streuungen der Fertigungsparameter.

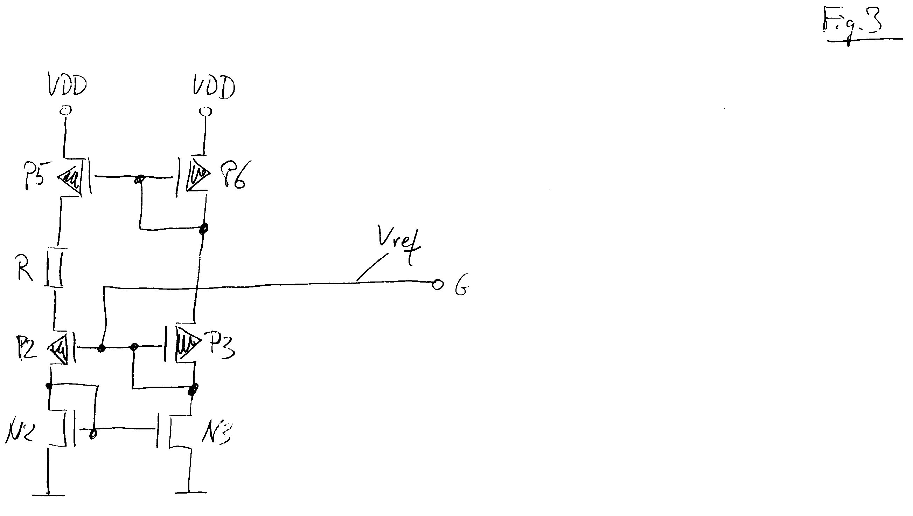

Figur 3 zeigt ein weiteres Ausführungsbeispiel des Doppelstromspiegels, mit dessen Hilfe das Referenzpotential Vref erzeugbar ist. Gegenüber dem Doppelstromspiegel in Figur 1 weist dieser zwischen dem Widerstandselement R und dem ersten Versorgungspotential VDD einen zusätzlichen fünften p-Kanal-Transistor P5 und zwischen dem dritten p-Kanal-Transistor P3 und dem ersten Versorgungspotential VDD einen zusätzlichen sechsten p-Kanal-Transistor P6 auf. Die Gates dieser beiden zusätzlichen Transistoren P5, P6 sind miteinander verbunden. Außerdem sind Drain und Gate des sechsten p-Kanal-Transistors P6 miteinander verbunden.

Durch den fünften P5 und sechsten P6 p-Kanal-Transistor wird erreicht, daß die Potentialdifferenz zwischen dem Referenzpotential Vref und dem ersten Versorgungspotential VDD größer ist, als beim Ausführungsbeispiel gemäß Figur 1.

Dadurch wird der vierte Feldeffekttransistor P4 weiter geöffnet. Dieser kann daher kleiner dimensioniert sein, um den gleichen Strom zu erzeugen.

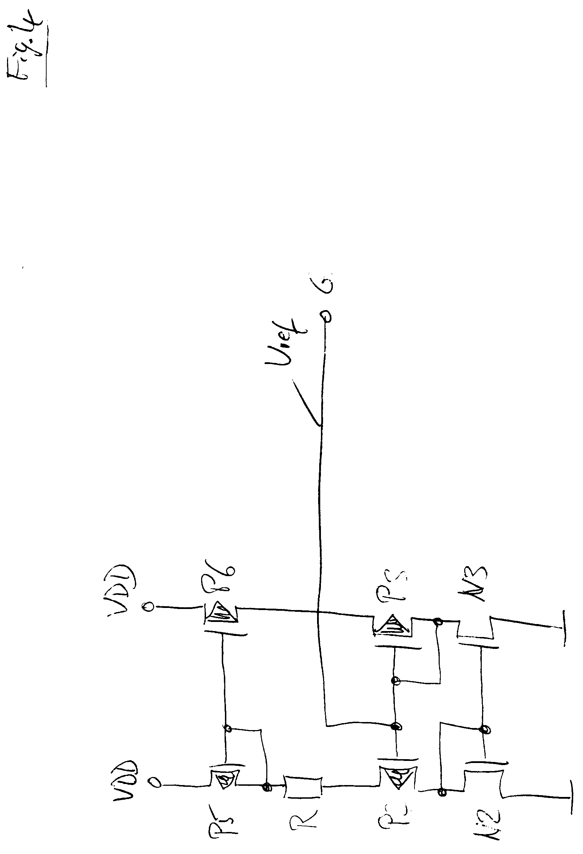

Wie Figur 4 zeigt, können bei dem Ausführungsbeispiel des Doppelstromspiegels nach Figur 3 anstelle von Drain und Gate des sechsten p-Kanal-Transistors P6 auch Drain und Gate des fünften p-Kanal-Transistors P5 miteinander verbunden sein.

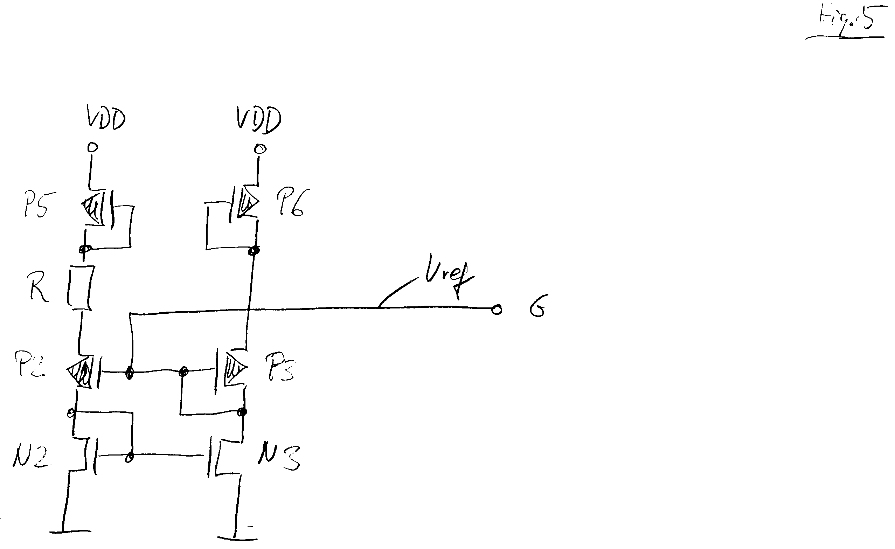

Figur 5 zeigt eine weitere Abwandlung des Ausführungsbeispiels aus Figur 3, bei dem sowohl Gate und Drain des fünften p-Kanal-Transistors P5 als auch des sechsten p-Kanal-Transistors P6 jeweils miteinander verbunden sind, wohingegen die Gates dieser beiden Transistoren P5, P6 nicht miteinander verbunden sind.

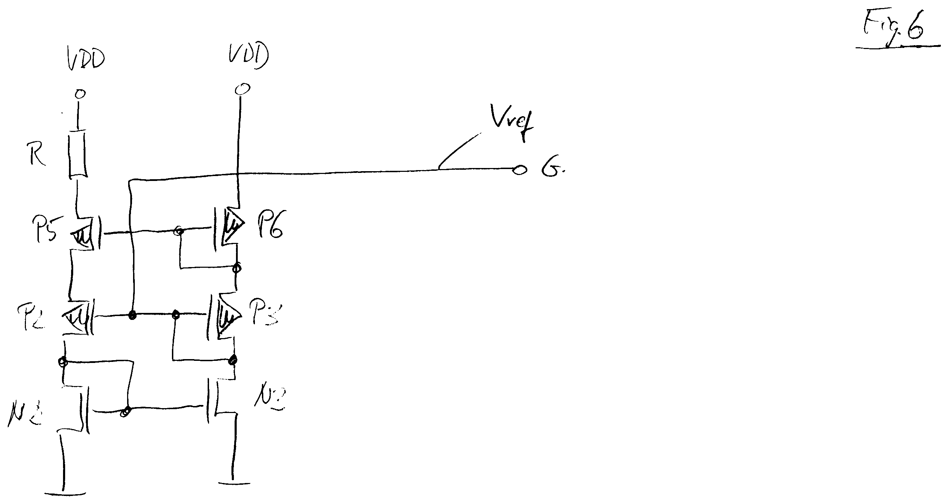

Figur 6 zeigt ein weiteres Ausführungsbeispiel des Doppelstromspiegels. In Abweichung vom in Figur 1 dargestellten Doppelstromspiegel ist zusätzlich zwischen dem zweiten p-Kanal-Transistor P2 und dem Widerstandselement R der fünfte p-Kanal-Transistor P5 und zwischen dem dritten p-Kanal-Transistor P3 und dem ersten Versorgungspotential VDD der sechste p-Kanal-Transistor P6 angeordnet. Die Gates der beiden zusätzlichen Transistoren P5, P6 sind miteinander verbunden. Ebenfalls sind Gate und Drain des sechsten p-Kanal-Transistors P6 miteinander verbunden.

Weitere Ausführungsformen ergeben sich durch andere Verbindung von Drain und Gate dieser beiden zusätzlichen Transistoren P5 und P6 in Figur 6, analog zu den in den Figuren 4 und 5 dargestellten Ausführungsbeispielen.

Betreibt man den Doppelstromspiegel im Unterschwellstrombereich (dies ist durch geeignete Dimensionierung erreichbar), so ist das Referenzpotential Vref unabhängig von technologisch bedingten Schwankungen des Widerstandswertes des Widerstandselementes R.

Es ist bei allen geschilderten Ausführungsbeispielen auch möglich, das Referenzpotential Vref nicht zwischen dem zweiten P2 und dem dritten P3 p-Kanal-Feldeffekttransistor, sondern zwischen dem zweiten N2 und dem dritten N3 n-Kanal-Feldeffekttransistor abzugreifen (siehe z.B. Figur 2). Die Konstanz der Spannung zwischen dem Referenzpotential Vref und dem ersten Versorgungspotential VDD ist dann jedoch etwas geringer, da die notwendige Anpassung bei Schwankungen des letzteren langsamer erfolgt.

Mit der erfindungsgemäßen integrierten Pufferschaltung sind weitgehend konstante Schaltzeiten erreichbar, auch wenn das erste Versorgungspotential VDD Werte zwischen 3V und 7V annimmt.

## Patentansprüche

1. Integrierte Pufferschaltung mit einem Eingang (IN) und einem Ausgang (OUT), die eine zwischen einem ersten (VDD) und einem zweiten (Masse) Versorgungspotential angeordnete Serienschaltung (S) mindestens einer spannungsgesteuerten Konstantstromquelle (I) und eines ersten Feldeffekttransistors (T1) aufweist,
wobei das Gate des ersten Feldeffekttransistors (T1) den Eingang (IN) bildet,
wobei die Serienschaltung (S) einen Schaltungsknoten zwischen der Konstantstromquelle (I) und dem ersten Feldeffekttransistor (T1) aufweist, der den Ausgang (OUT) bildet
und wobei die Konstantstromquelle (I) über einen Steuereingang (G) mit einem Referenzpotential (Vref) steuerbar ist, welches gegenüber dem ersten Versorgungspotential (VDD) eine konstante Potentialdifferenz aufweist,
**dadurch gekennzeichnet,**
daß ein Widerstandselement (R), ein zweiter Feldeffekttransistor eines ersten Kanal-Typs (P2) und ein zweiter Feldeffekttransistor eines zweiten Kanal-Typs (N2) in Serie zwischen dem ersten (VDD) und dem zweiten (Masse) Versorgungspotential angeordnet sind,
daß ein dritter Feldeffekttransistor des ersten Kanal-Typs (P3) und ein dritter Feldeffekttransistor des zweiten Kanal-Typs (N3) in Serie zwischen dem ersten (VDD) und dem zweiten (Masse) Versorgungspotential angeordnet sind,
daß Gate und Drain des dritten Feldeffekttransistors des ersten Kanal-Typs (P3) miteinander verbunden sind,
daß Gate und Drain des zweiten Feldeffekttransistors des zweiten Kanal-Typs (N2) miteinander verbunden sind,
daß die Gates des zweiten (N2) und des dritten (N3) Feldeffekttransistors des zweiten Kanal-Typs miteinander verbunden sind
und daß die Gates des zweiten (P2) und des dritten (P3) Feldeffekttransistors des ersten Kanal-Typs miteinander und mit dem Steuereingang (G) verbunden sind.

2. Integrierte Pufferschaltung gemäß Anspruch 1,
**dadurch gekennzeichnet,**
daß der Steuereingang (G) statt mit dem Gate des zweiten (P2) und des dritten (P3) Feldeffekttransistors des ersten Kanal-Typs mit den Gates des zweiten (N2) und des dritten (N3) Feldeffekttransistors des zweiten Kanal-Typs verbunden ist.

3. Integrierte Pufferschaltung gemäß einem der vorstehenden Ansprüche,
**dadurch gekennzeichnet,**
daß die Konstantstromquelle (I) einen vierten Feldeffekttransistor vom ersten Kanal-Typ (P4) aufweist, dessen Gate der Steuereingang (G) ist.

4. Integrierte Pufferschaltung gemäß Anspruch 3,
**dadurch gekennzeichnet,**
daß der erste Kanal-Typ ein p-Kanal-Typ ist
und daß die Source des vierten Feldeffekttransistors vom ersten Kanal-Typ (P4) mit dem ersten Versorgungspotential (VDD) verbunden ist.

5. Integrierte Pufferschaltung gemäß einem der vorstehenden Ansprüche,
**dadurch gekennzeichnet,**
daß zwischen dem Widerstandselement (R) und dem ersten Versorgungspotential (VDD) ein fünfter Feldeffekttransistor vom ersten Kanal-Typ (P5) angeordnet ist,
daß zwischen dem dritten Feldeffekttransistor vom ersten Kanal-Typ (P3) und dem ersten Versorgungspotential (VDD) ein sechster Feldeffekttransistor vom ersten Kanal-Typ (P6) angeordnet ist,
daß die Gates des fünften (P5) und sechsten (P6) Feldeffekttransistors vom ersten Kanal-Typ miteinander verbunden sind
und daß Gate und Drain des sechsten Feldeffekttransistors vom ersten Kanal-Typ (P6) miteinander verbunden sind.

6. Integrierte Pufferschaltung gemäß einem der Ansprüche 1 bis 4,
**dadurch gekennzeichnet,**
daß zwischen dem Widerstandselement (R) und dem ersten Versorgungspotential (VDD) ein fünfter Feldeffekttransistor vom ersten Kanal-Typ (P5) angeordnet ist,
daß zwischen dem dritten Feldeffekttransistor vom ersten Kanal-Typ (P3) und dem ersten Versorgungspotential (VDD) ein sechster Feldeffekttransistor vom ersten Kanal-Typ (P6) angeordnet ist,
daß die Gates des fünften (P5) und sechsten (P6) Feldeffekttransistors vom ersten Kanal-Typ miteinander verbunden sind
und daß Gate und Drain des fünften Feldeffekttransistors vom ersten Kanal-Typ (P5) miteinander verbunden sind.

7. Integrierte Pufferschaltung gemäß einem der Ansprüche 1 bis 4,
**dadurch gekennzeichnet,**
daß zwischen dem Widerstandselement (R) und dem ersten Versorgungspotential (VDD) ein fünfter Feldeffekttransistor vom ersten Kanal-Typ (P5) angeordnet ist,
daß zwischen dem dritten Feldeffekttransistor vom ersten Kanal-Typ (P3) und dem ersten Versorgungspotential (VDD) ein sechster Feldeffekttransistor vom ersten Kanal-Typ (P6) angeordnet ist,
daß Gate und Drain des fünften Feldeffekttransistors vom ersten Kanal-Typ (P5) miteinander verbunden sind
und daß Gate und Drain des sechsten Feldeffekttransistors vom ersten Kanal-Typ (P6) miteinander verbunden sind.

8. Integrierte Pufferschaltung gemäß einem der Ansprüche 1 bis 4,
**dadurch gekennzeichnet,**
daß zwischen dem zweiten Feldeffekttransistor vom ersten Kanal-Typ (P2) und dem Widerstandselement (R) ein fünfter Feldeffekttransistor vom ersten Kanal-Typ (P5) angeordnet ist,
daß zwischen dem dritten Feldeffekttransistor vom ersten Kanal-Typ (P3) und dem ersten Versorgungspotential (VDD) ein sechster Feldeffekttransistor vom ersten Kanal-Typ (P6) angeordnet ist,
daß die Gates des fünften (P5) und sechsten (P6) Feldeffekttransistors vom ersten Kanal-Typ miteinander verbunden sind
und daß Gate und Drain des sechsten Feldeffekttransistors vom ersten Kanal-Typ (P6) miteinander verbunden sind.

9. Integrierte Pufferschaltung gemäß einem der Ansprüche 1 bis 4,
**dadurch gekennzeichnet,**
daß zwischen dem zweiten Feldeffekttransistor vom ersten Kanal-Typ (P2) und dem Widerstandselement (R) ein fünfter Feldeffekttransistor vom ersten Kanal-Typ (P5) angeordnet ist,
daß zwischen dem dritten Feldeffekttransistor vom ersten Kanal-Typ (P3) und dem ersten Versorgungspotential (VDD) ein sechster Feldeffekttransistor vom ersten Kanal-Typ (P6) angeordnet ist,
daß die Gates des fünften (P5) und sechsten (P6) Feldeffekttransistors vom ersten Kanal-Typ miteinander verbunden sind
und daß Gate und Drain des fünften Feldeffekttransistors vom ersten Kanal-Typ (P5) miteinander verbunden sind.

10. Integrierte Pufferschaltung gemäß einem der Ansprüche 1 bis 4,
**dadurch gekennzeichnet,**
daß zwischen dem zweiten Feldeffekttransistor vom ersten Kanal-Typ (P2) und dem Widerstandselement (R) ein fünfter Feldeffekttransistor vom ersten Kanal-Typ (P5) angeordnet ist,
daß zwischen dem dritten Feldeffekttransistor vom ersten Kanal-Typ (P3) und dem ersten Versorgungspotential (VDD) ein sechster Feldeffekttransistor vom ersten Kanal-Typ (P6) angeordnet ist,
daß Gate und Drain des fünften Feldeffekttransistors vom ersten Kanal-Typ (P5) miteinander verbunden sind
und daß Gate und Drain des sechsten Feldeffekttransistors vom ersten Kanal-Typ (P6) miteinander verbunden sind.
